# EUROPÄISCHE PATENTSCHRIFT

(11) **EP 2 724 463 B1**
(45) Veröffentlichungstag und Bekanntmachung des Hinweises auf die Patenterteilung: **31.08.2016**
(21) Anmeldenummer: 12747879.0
(22) Anmeldetag: 18.06.2012
(51) Int. Cl.: H01P 5/16, H03F 1/56, H03F 3/189, H03F 3/193, H03F 3/21, H03F 3/24

(54) **VERFAHREN UND VORRICHTUNG ZUM SCHUTZ EINES HOCHFREOUENZ-LEISTUNGSVERSTÄRKERS GEGEN FEHLABSCHLUSS**
METHOD AND DEVICE FOR PROTECTING A HIGH-FREQUENCY POWER AMPLIFIER AGAINST A TERMINATION FAULT
PROCÉDÉ ET DISPOSITIF DE PROTECTION D'UN AMPLIFICATEUR DE PUISSANCE À HAUTE FRÉQUENCE CONTRE UNE TERMINAISON DÉFECTUEUSE

(30) Priorität: 27.06.2011 DE 102011106234
(43) Veröffentlichungstag der Anmeldung: 30.04.2014
(73) Patentinhaber: Tesat-Spacecom GmbH & Co. KG, 71522 Backnang (DE)
(72) Erfinder: KHILLA, Abdel-Messiah, 71522 Backnang (DE); SCHÄUFLER, Jürgen, 71522 Backnang (DE)
(86) Internationale Anmeldenummer: PCT/DE2012/000625
(87) Internationale Veröffentlichungsnummer: WO 2013/000451

(56) Entgegenhaltungen:
- EP-A1- 0 404 294
- EP-A1- 1 557 942
- WO-A1-87/03378
- WO-A2-2008/002704
- JP-A- 6 268 536
- US-A- 3 641 451
- US-A- 3 852 669
- US-A- 4 019 150
- US-A- 4 122 400
- US-A- 4 165 493
- US-A- 4 353 037
- US-A- 4 422 047
- US-A- 5 196 808
- US-A- 5 994 965
- US-A1- 2001 003 433
- US-A1- 2002 094 791
- US-A1- 2003 114 182
- US-A1- 2003 218 507
- US-A1- 2004 100 325
- US-A1- 2007 026 838

## Beschreibung

Vorliegende Erfindung betrifft eine Fehlanpassungsschutzschaltung bei Hochfrequenz-Leistungsverstärkem für den Fall, dass ausgangsseitig eine Fehlimpedanzanpassung vorliegt.

### Stand der Technik

Hochfrequenz-Leistungsverstärker werden in einem Wellenleiter-System mit einer vorgegebenen Impedanz, z. B. 50 OHM dimensioniert. Um eine ungestörte Funktion des Leistungsverstärkers und eine maximale Leistungsabgabe in das anschließende System, wie z. B. eine Antennen-Sammelschiene zu gewährleisten, muss das anschließende System die gleiche Leitungsimpedanz aufweisen wie der Leistungsverstärker.

Bei unterschiedlicher Impedanzen an der Verbindungsstelle kommt es zu Reflektionen, durch die ein Teil der Leistung in die Verstärker-Endstufe zurückgeführt wird. Im kritischsten Fall eines fehlenden Anschlusses; d. h. eines Leerlaufs oder eines

Kurzschlusses wird die gesamte Hochfrequenz-Leistung des Verstärkers in diesen zurückgeführt.

Ein derartiger Fall kann während der Inbetriebnahme oder bei Messungen solcher Verstärker durch Bedienungs- und/oder Handhabungsfehler eintreten.

Hochfrequenz-Leistungsverstärker, deren Endstufen unter Einsatz von Transistoren aufgebaut sind, können durch die reflektierten Leistungsanteile des Verstärkers thermisch derart belastet werden, dass die Halbleiterbauelemente geschädigt oder sogar zerstört werden.

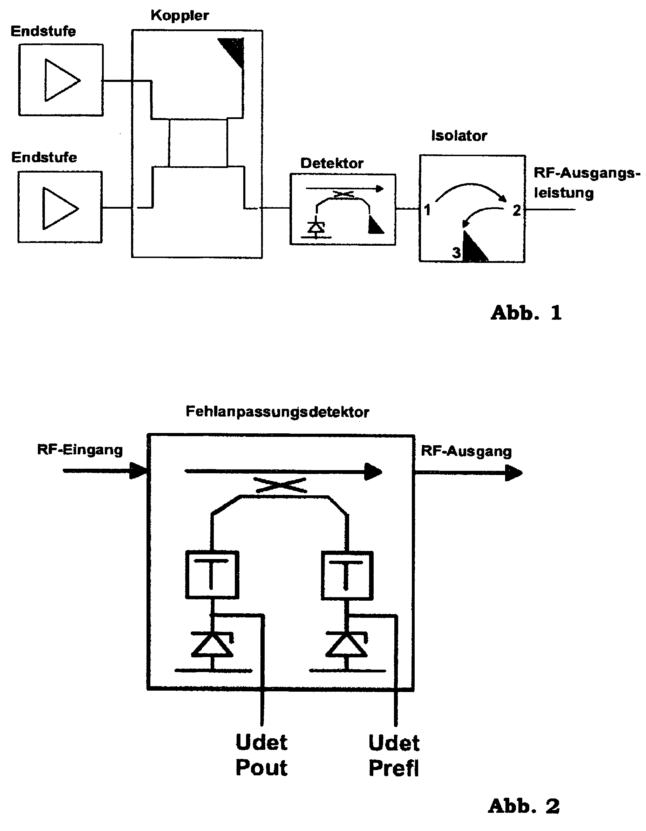

Um derartige Endstufen gegen reflektierte Leistungen im Fall eines Fehlabschlusses zu schützen, werden derzeit am Ausgang eines Hochfrequenz-Transistorleistungsverstärkers Zirkulatoren angebracht, wie in Abbildung 1 am Beispiel der Ausgangs-Sektion eines Leistungsverstärkers mit parallelen Endstufen dargestellt ist.

Die als Dreitor ausgelegten Schaltungen weisen eine richtungsabhängige Wellenleitung auf. Die an ┌or 1 eingespeiste Leistung wird verlustarm zum Tor 2 geführt. Die an Tor 2 eingespeiste Leistung bzw. die von dort reflektierte Leistung, im Fall eines Fehlabschlusses des RF-Ausgangs, wird zum Tor 3 weitergeführt. Indem Tor 3 mit einem Lastwiderstand mit der Größe des Bezugssystems abgeschlossen wird, wird die komplette an Tor 3 ausgeführte Leistung absorbiert und nicht erneut von Tor 3 zu Tor 1 reflektiert. Ein Zirkulator, dessen drittes Tor mit einem Lastwiderstand abgeschlossen ist, wirkt als Isolator.

US 5,994,965 beschreibt einen Hochleistungsverstärker mit unabhängigen, fehlertoleranten Verstärkermodulen, wovon jedes einen Verstärker mit einer Mehrzahl von Silizium-Karbid Transistorschaltungen aufweist.

### Problemstellung

In den letzten Jahren sind für die Verwendung in Hochfrequenz-Leistungsverstärkem neue Transistoren auf der Basis von Gallium-Nitrid entwickelt worden. Diese haben Ausgangs-Leistungen bis zu 200 Watt. Da sie gleichzeitig auch sehr hohe Wirkungsgrade aufweisen, sind sie für die Verwendung in Leistungsverstärkern für Satellitenanwendungen geeignet. Gleichzeitig ist aber in der Satellitenanwendung auch Verlustarmut der Ausgangsnetzwerke hinter dem Leistungsverstärker gefordert, um den Wirkungsgrad des Verstärkers nicht zu beeinträchtigen. Weiterhin sind geringe Baugrößen und Gewichte der Geräte notwendig.

Um derartige Leistungsverstärker gegen reflektierte Leistungen bei Fehlabschluss zu schützen, wären Isolatoren notwendig, deren Abschlusswiderstand am dritten Tor die volle Leistung von bis zu 200 Watt absorbieren kann. Solche Isolatoren sind im Hochfrequenzbereich mit der gleichzeitig geforderten Verlustarmut und geringer Baugröße nicht zu realisieren.

Aufgabe der Erfindung ist es, bei Hochfrequenz-Leistungsverstärkern der hier zur Rede stehenden Art Abhilfe bei Fehlanpassung zu schaffen. Diese Aufgabe wird mit Hilfe der Merkmale aus Anspruch 1 und Anspruch 6 erreicht.

Nachstehend wird die Erfindung an Hand der Zeichnungen näher beschrieben, von denen
- Abbildung 1: den Stand der Technik mit einem Zirkulator,
- Abbildung 2: die prinzipielle Schaltung eines Fehlanpassungsdetektors,
- Abbindung 3: Koppeldämpfung und Isolation (Richtschärfe) des Kopplers,
- Abbildung 4: eine Fehlanpassungsschutzschaltung nach der Erfindung und
- Abbildung 5: einen Ausgangs-Kombinierer zweier paralleler Endstufen mit Fehlanpassungsschutzschaltung zeigen.

Die erfindungsgemäße Anpassungsschutzschaltung für Hochfrequenz-Leistungsverstärker weist einen am Ausgang des Leistungsverstärkers angebrachten Detektor auf, der als Wellenleiter-Koppler ausgebildet ist, und dessen in Durchgangsrichtung entkoppeltes Tor mit einem Lastwiderstand abgeschlossen ist. Da dieses Tor für reflektierte Wellen vom Ausgang eine geringere Koppeldämpfung aufweist als die für die Endstufen eingespeiste Leistung, ist dieses ebenfalls mit einer Detektordiode abgeschlossen (Abbildung 2).

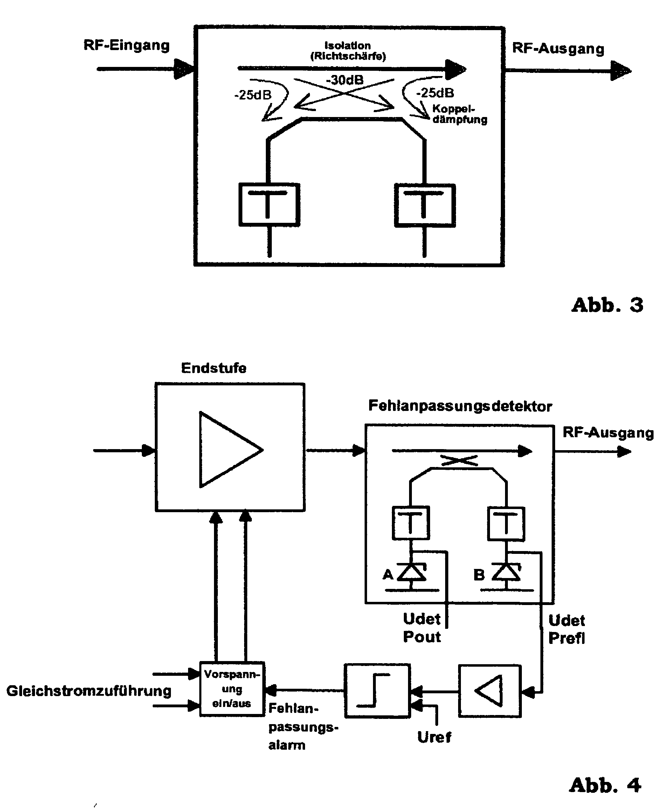

Die Dimensionierung des Kopplers wird so ausgelegt, dass gewährleistet ist, dass die Koppeldämpfung in das jeweils angekoppelte Tor mit z. B. -25 dB geringer ist als die Dämpfung in das jeweils entkoppelte Tor mit z. B. -30 dB (vgl. Abbildung 3). Somit ist eine eindeutige Unterscheidbarkeit der Herkunft der in beiden Detektordioden anliegenden Signalpegel und deren Zuordnung zu den Detektordioden gegeben.

Die von den beiden Detektordioden gelieferten, den jeweiligen anliegenden Leistungspegeln proportionalen Spannungen werden in Regelschaltungen weiterverarbeitet.

Die von Diode A gelieferte Spannung entspricht der in den Ausgang eingespeisten Nutzleistung. Diese wird wie bisher in der Regelschaltung genutzt, um z. B. im ALC-Betrieb und/oder über Temperatur die Ausgangsleistung konstant zu halten bzw. als Telemetriedaten an das zu überwachende System weitergeleitet zu werden.

Die von der Diode B gelieferte Spannung ist der Leistung proportional, die am Ausgang des Leistungsverstärkers durch den Abschluss mit einer nicht-idealen Impedanz reflektiert wird. Wie aus Abbildung 4 hervorgeht, kann diese Spannung nach entsprechender Verstärkung und/oder Aufbereitung in analoger oder digitaler Form in die Schaltung eingespeist werden, die die Endstufe ein- und ausschaltet. Bei Überschreiten eines vordefinierten Pegels Uref wird über einen Fehlanpassungsalarm ein schnelles Abschalten der Endstufe bewirkt.

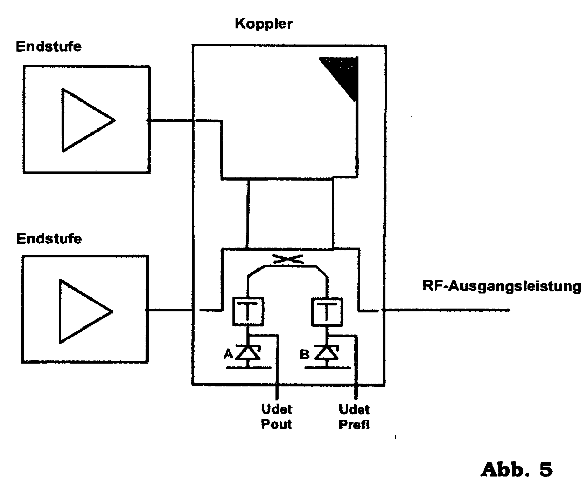

Für den oftmals gegebenen Fall paralleler Endstufen werden diese über einen als Addierer genutzten Koppler zusammengefügt. Dieser Koppler ist aus Gründen der Verlustarmut meist als Verzweigungskoppler in Streifenleistungstechnik realisiert. In diesem Fall kann der Fehlanpassungskoppler, wie in Abbildung 5 gezeigt, in diesen Koppler integriert werden, wodurch die Durchgangsverluste der Gesamtanordnung nochmals reduziert werden, während gleichzeitig sowohl die klassische Telemetrierung der RF-Ausgangsleistung als auch der Fehlanpassungsschutz realisiert werden können.

## Patentansprüche

1. Verfahren zum Schutz eines Hochfrequenz-Leistungsverstärkers mit hoher Ausgangsleistung und hohem Wirkungsgrad gegen Fehlabschluss, wobei der Hochfrequenz-Leistungsverstärkers zwei parallele Endstufen aufweist;
wobei dem Hochfrequenz-Leistungsverstärker ausgangsseitig eine Fehlanpassungsschutzschaltung, welche von einem Wellenleiter-Koppler gebildet wird, zugeschaltet wird,
wobei von ersten und zweiten Detektordioden A bzw. B der Fehlanpassungsschutzschaltung erste und zweite Spannungen abgeleitet werden, die proportional zu den an den Detektordioden anliegenden Leistungspegeln sind, wobei die erste Spannung der in den Ausgang eingespeisten Nutzleistung und die zweite Spannung der reflektierten Leistung entspricht,
wobei die abgeleiteten Spannungen einem Regelschaltkreis zugeführt werden und
wobei der Regelschaltkreis die Endstufe oder Endstufen des Verstärkers oder der Verstärker ab- oder anschaltet, je nachdem eine vorgegebene Referenzspannung durch die von Diode B abgeleitete Spannung über- bzw. unterschritten wird, und
wobei der Wellenleiter-Koppler derart ausgelegt wird, dass die Koppeldämpfung in das jeweils angekoppelte Tor geringer ist als die Dämpfung in das jeweils entkoppelte Tor und dadurch eine eindeutige Zuordnung der anliegenden Signalpegel zu der ersten oder zweiten Detektordiode ermöglicht
wobei die Ausgänge der Endstufen mittels eines Addierer fungierenden Kopplers zusammengeführt werden, und
wobei in den Koppler die Fehlanpassungsschutzschaltung integriert ist, so dass die Durchgangsverluste der Gesamtanordnung des Hochfrequenz-Leistungsverstärkers reduziert werden können.

2. Verfahren zum Schutz eines Hochfrequenz-Leistungsverstärkers gegen Fehlabschluss nach Anspruch 1,
wobei die Fehlanpassungsschutzschaltung von einem Wellenleiter-Koppler gebildet wird, dessen in Durchgangsrichtung entkoppeltes Tor mit einem Lastwiderstand abgeschlossen ist.

3. Verfahren nach einem der vorhergehenden Ansprüche,
wobei die in den Ausgang eingespeiste Nutzleistung der von der Diode A gelieferten Spannung entspricht und dazu benutzt werden kann im ALC-Betrieb und/oder über Temperatur die Ausgangsleistung des Verstärkers konstant zu halten oder als Telemetriedaten das Überwachungssystem zu steuern.

4. Verfahren nach einem der vorhergehenden Ansprüche,
wobei die von der Diode B gelieferte Spannung der am Ausgang des Leistungsverstärkers durch den Fehlabschluss reflektierten Leistung entspricht.

5. Verfahren nach einem der vorhergehenden Ansprüche,
wobei die von Diode B gelieferte Spannung nach entsprechender Verstärkung oder Aufbereitung in analoger oder digitaler Form in die Fehlanpassungsschutzschaltung eingespeist wird, um die Endstufe oder Endstufen auszuschalten, so bald ein vorgegebener Pegel Uref überschritten wird.

6. Schaltung zum Schutz eines Hochfrequenz-Leistungsverstärkers mit hoher Ausgangsleistung und hohem Wirkungsgrad gegen Fehlabschluss, wobei der Hochfrequenz-Leistungsverstärker zwei parallele Endstufen aufweist, wobei die Schaltung ausgeführt ist, das Verfahren nach Anspruch 1 durchzuführen,
wobei ein am Ausgang des Hochfrequenz-Leistungsverstärkers geschalteter Wellenleiter-Koppler mit einer ersten Detektordiode A, die entsprechenden dem anliegenden Leistungspegel eine erste Spannung liefert, die der eingespeisten Nutzleistung entspricht, und wobei eine zweite Detektordiode B deren ausgegebene zweite Spannung der durch Fehlanpassung reflektierten Leistung entspricht,
wobei ein Regelschaltkreis, mit dem aus der Differenz des Spannungswertes an Diode B und einer Referenzspannung das Ausmaß einer Fehlanpassung festgestellt wird und die Endstufen des Hochfrequenz-Leistungsverstärkers oder der Hochfrequenz-Leistungsverstärker an- oder abgeschaltet werden, je nachdem ob die Spannungsdifferenz einen gegebenen Referenzwert Uref unter- oder überschreitet,
wobei der Wellenleiter-Koppler derart ausgelegt wird, dass die Koppeldämpfung in das jeweils angekoppelte Tor geringer ist als die Dämpfung in das jeweils entkoppelte Tor und dadurch eine eindeutige Zuordnung der anliegenden Signalpegel zu der ersten oder zweiten Detektordiode ermöglicht,
wobei die Ausgänge der Endstufen mittels eines als Addierer fungierenden Kopplers zusammengeführt sind und
wobei die Schaltung in den Koppler integriert ist, so dass die Durchgangsverluste des Hochfrequenz-Leistungsverstärkers reduziert werden.

7. Schaltung nach Anspruch 6,
wobei die von der Diode A gelieferte Spannung der in den Ausgang eingespeisten Nutzleistung entspricht, die in einer Regelschaltung dazu genutzt werden kann, um z. B. im ALC-Betrieb und/oder über Temperatur die Ausgangsleistung des Verstärkers konstant zuhalten bzw. als Telemetriedaten für ein Überwachungssystem zu dienen.

8. Schaltung nach Anspruch 6,
wobei die von der Diode B gelieferte Spannung der Leistung proportional ist, die am Ausgang des Leistungsverstärkers durch einen Abschluss mit einer nicht-idealen Impedanz reflektiert wird.

9. Schaltung nach Anspruch 6,
wobei die von der Diode B gelieferte Spannung nach entsprechender Verstärkung oder Aufbereitung in analoger oder digitaler Form in die Schaltung eingespeist wird und bei Überschreiten eines vordefinierten Pegels Uref die Endstufen ein- oder ausschaltet.

10. Schaltung nach mindestens einem der vorangegangenen Ansprüche 6 bis 9,
wobei das in Durchgangsrichtung entkoppeltes Tor des WellenleiterKopplers mit einem Lastwiderstand abgeschlossen ist.

11. Schaltung nach mindestens einem der vorrangegangenen Ansprüche 6 bis 10,
wobei das in Durchgangsrichtung entkoppelte Tor für reflektierte Wellen vom Ausgang des Leistungsverstärkers eine geringere Koppeldämpfung aufweist als für die von den Endstufen eingespeiste Leistung.

12. Schaltung nach Anspruch 6,
wobei der Koppler als Verzweigungskoppler in Streifenleitungstechnik ausgebildet ist.

## Claims

1. Method for protecting a radio-frequency power amplifier having a high output power and a high efficiency against faulty termination, wherein the radio-frequency power amplifier comprises two parallel output stages;
wherein a mismatch protective circuit formed by a waveguide coupler is connected to the radio-frequency power amplifier on the output side,
wherein first and second voltages are derived from first and second detector diodes A and B, respectively, of the mismatch protective circuit, said voltages being proportional to the power levels present at the detector diodes, wherein the first voltage corresponds to the useful power fed into the output and the second voltage corresponds to the reflected power,
wherein the derived voltages are fed to a control circuit,
and wherein the control circuit switches the output stage or output stages of the amplifier or of the amplifiers off or on depending on whether a predefined reference voltage is exceeded or undershot by the voltage derived from diode B, and
wherein the waveguide coupler is designed in such a way that the coupling attenuation into the respectively coupled port is lower than the attenuation into the respectively decoupled port and thereby enables an unambiguous assignment of the signal levels present to the first or second detector diode,
wherein the outputs of the output stages are combined by means of a coupler functioning as adder and
wherein the mismatch protective circuit is integrated into the coupler, such that the throughput losses of the overall arrangement of the radio-frequency power amplifier can be reduced.

2. Method for protecting a radio-frequency power amplifier against faulty termination according to Claim 1,
wherein the mismatch protective circuit is formed by a waveguide coupler whose port that is decoupled in the throughput direction is terminated with a load resistor.

3. Method according to either of the preceding claims,
wherein the useful power fed into the output corresponds to the voltage supplied by the diode A and can be used, in ALC operation and/or by means of temperature, to keep the output power of the amplifier constant or to control the monitoring system as telemetry data.

4. Method according to any of the preceding claims,
wherein the voltage supplied by the diode B corresponds to the power reflected at the output of the power amplifier as a result of the faulty termination.

5. Method according to any of the preceding claims,
wherein the voltage supplied by the diode B, after corresponding amplification or conditioning, is fed in analogue or digital form into the mismatch protective circuit in order to switch off the output stage or output stages as soon as a predefined level Uref is exceeded.

6. Circuit for protecting a radio-frequency power amplifier having a high output power and a high efficiency against faulty termination, wherein the radio-frequency power amplifier comprises two parallel output stages, wherein the circuit is configured to carry out the method according to Claim 1,
wherein a waveguide coupler connected to the output of the radio-frequency power amplifier comprising a first detector diode A, which supplies a first voltage corresponding to the power level present, said first corresponding to the useful power fed in,
wherein a second detector diode B, the output second voltage of which corresponds to the power reflected as a result of faulty termination,
wherein a control circuit, with which the extent of a mismatch is ascertained from the difference between the voltage value at diode B and a reference voltage and the output stages of the radio-frequency power amplifier or of the radio-frequency power amplifiers are switched on or off depending on whether the voltage difference undershoots or exceeds a given reference value Uref,
wherein the waveguide coupler is designed in such a way that the coupling attenuation into the respectively coupled port is lower than the attenuation into the respectively decoupled port and thereby enables an unambiguous assignment of the signal levels present to the first or second detector diode,
wherein the outputs of the output stages are combined by means of a coupler functioning as adder and
wherein the circuit is integrated into the coupler, such that the throughput losses of the radio-frequency power amplifier are reduced.

7. Circuit according to Claim 6,
wherein the voltage supplied by the diode A corresponds to the useful power fed into the output, which can be used in a control circuit in order, for example, in ALC operation and/or by means of temperature, to keep the output power of the amplifier constant or to serve as telemetry data for a monitoring system.

8. Circuit according to Claim 6,
wherein the voltage supplied by the diode B is proportional to the power that is reflected at the output of the power amplifier as a result of a termination with a non-ideal impedance.

9. Circuit according to Claim 6,
wherein the voltage supplied by the diode B, after corresponding amplification or conditioning, is fed in analogue or digital form into the circuit and switches the output stages on or off upon a predefined level Uref being exceeded.

10. Circuit according to at least one of the preceding Claim 6 to 9,
wherein the port of the waveguide coupler that is decoupled in the throughput direction is terminated with a load resistor.

11. Circuit according to at least one of the preceding Claims 6 to 10,
wherein the port for reflective waves from the output of the power amplifier, which port is decoupled in the throughput direction, has a lower coupling attenuation than for the power fed in from the output stages.

12. Circuit according to Claim 6,
wherein the coupler is embodied as a branch coupler using stripline technology.

## Revendications

1. Procédé de protection d'un amplificateur de puissance ayant une puissance de sortie élevée et un rendement élevé contre une terminaison défectueuse, dans lequel l'amplificateur de puissance à haute fréquence comprend deux étages finaux parallèles ;
dans lequel un circuit de protection contre une désadaptation qui est constitué d'un coupleur de guide d'ondes est connecté en sortie à l'amplificateur de puissance à haute fréquence,
dans lequel des première et seconde tensions sont dérivées de première et seconde diodes de détection A ou B du circuit de protection contre une désadaptation, lesquelles tensions sont proportionnelles aux niveaux de puissance appliqués aux diodes de détection, dans lequel la première tension correspond à la tension utile injectée dans la sortie et la seconde tension correspond à la puissance réfléchie,
dans lequel les tensions dérivées sont délivrées à un circuit de régulation et
dans lequel le circuit de régulation désactive ou active l'étage final ou les étages finaux de l'amplificateur ou des amplificateurs chaque fois qu'une tension de référence prédéterminée est franchie en sens croissant ou décroissant par la tension dérivée de la diode B, et
dans lequel le coupleur de guide d'ondes est réalisé de manière à ce que l'affaiblissement de couplage soit plus faible dans la porte couplée respective que l'affaiblissement dans la porte découplée respective et permet ainsi une association biunivoque du niveau de signal présent avec la première ou la seconde diode de détection,
dans lequel les sorties des étages finaux sont combinées au moyen d'un coupleur à fonction d'additionneur ; et
dans lequel le circuit de protection contre une désadaptation est intégré au coupleur de manière à ce que les pertes en sens passant de l'ensemble de l'amplificateur de puissance à haute fréquence puissent être réduites.

2. Procédé de protection d'un amplificateur de puissance à haute fréquence contre une terminaison défectueuse selon la revendication 1,
dans lequel le circuit de protection contre une désadaptation est formé par un coupleur de guide d'ondes dont la porte découplée en sens passant est terminée par une résistance de charge.

3. Procédé selon l'une quelconque des revendications précédentes,
dans lequel la puissance utile injectée dans la sortie correspond à la tension délivrée par la diode A et peut être utilisée pour maintenir constante la puissance de sortie de l'amplificateur lors d'un fonctionnement de type ALC et/ou en fonction de la température ou pour commander le système de surveillance en tant que données de télémétrie.

4. Procédé selon l'une quelconque des revendications précédentes,
dans lequel la tension délivrée par la diode B correspond à la puissance réfléchie à la sortie de l'amplificateur de puissance par la terminaison défectueuse.

5. Procédé selon l'une quelconque des revendications précédentes,
dans lequel la tension délivrée par la diode B après une amplification ou un traitement correspondant sous forme analogique ou numérique est injectée dans le circuit de protection contre une désadaptation afin de déconnecter l'étage final ou les étages finaux dès qu'un niveau prédéterminé Uref est dépassé.

6. Circuit de protection d'un amplificateur de puissance à haute fréquence ayant une puissance de sortie élevée et un rendement élevé contre une terminaison défectueuse, dans lequel l'amplificateur de puissance à haute fréquence comprend deux étages finaux parallèles, dans lequel le circuit est réalisé pour mettre en oeuvre le procédé selon la revendication 1, comprend un coupleur de guide d'ondes connecté à la sortie de l'amplificateur de puissance à haute fréquence ayant une première diode de détection A qui délivre une première tension correspondant au niveau de puissance injecté, laquelle tension correspond à la puissance utile injectée, et
une seconde diode de détection B dont la seconde tension délivrée en sortie correspond à la puissance réfléchie par la terminaison défectueuse,
un circuit de régulation au moyen duquel la valeur d'une désadaptation est établie à partir de la différence entre la valeur de tension au niveau de la diode B et une tension de référence et les étages finaux de l'amplificateur de puissance à haute fréquence ou des amplificateurs de puissance à haute fréquence sont activés ou désactivés chaque fois que la différence de tension franchit une valeur de référence définie Uref en sens décroissant ou croissant,
dans lequel le coupleur de guide d'ondes est conçu de manière à ce que l'affaiblissement de couplage soit plus faible dans la porte couplée respective que l'affaiblissement dans la porte découplée respective et permette ainsi une association biunivoque du niveau de signal appliqué avec la première ou la seconde diode de détection,
dans lequel les sorties des étages finaux sont combinés au moyen d'un coupleur à fonction d'additionneur, et dans lequel le circuit est intégré au coupleur de manière à ce que les pertes de transmission de l'amplificateur de puissance à haute fréquence soient réduites.

7. Circuit selon la revendication 6,
dans lequel la tension délivrée par la diode A correspond à la puissance utile dans la sortie, qui peut être utilisée dans un circuit de régulation pour maintenir constante la puissance de sortie de l'amplificateur, par exemple lors d'un fonctionnement de type ALC et/ou en fonction de la température, ou pour l'utiliser en tant que données de télémétrie pour un système de surveillance.

8. Circuit selon la revendication 6,
dans lequel la tension délivrée par la diode B est proportionnelle à la puissance qui est réfléchie à la sortie de l'amplificateur de puissance par une terminaison ayant une impédance non idéale.

9. Circuit selon la revendication 6,
dans lequel la tension délivrée par la diode B après une amplification ou un traitement correspondant sous forme analogique ou numérique est injectée dans le circuit et active ou désactive les étages finaux lorsqu'un niveau prédéfini Uref est dépassé.

10. Circuit selon au moins l'une des revendications 6 à 9 précédentes,
dans lequel la porte découplée en sens passant du coupleur de guide d'ondes est terminée par une résistance de charge.

11. Circuit selon au moins l'une des revendications 6 à 10 précédentes,
dans lequel la porte découplée en sens passant pour des ondes réfléchies par la sortie de l'amplificateur de puissance présente un affaiblissement de couplage plus faible que pour la puissance injectée par les étages finaux.

12. Circuit selon la revendication 6,
dans lequel le coupleur est réalisé sous la forme d'un coupleur de dérivation selon la technique des guides d'ondes à rubans.
